# EUROPÄISCHE PATENTANMELDUNG

(11) **EP 2 682 194 A1**
(43) Veröffentlichungstag der Anmeldung: **08.01.2014**
(21) Anmeldenummer: 12175112.7
(22) Anmeldetag: 05.07.2012
(51) Int. Cl.: B05B 13/02, B05C 11/08

(54) **Vorrichtung und Verfahren zum Behandeln einer Oberfläche eines Substrats mit einer Flüssigkeit**

(71) Anmelder: Singulus Stangl Solar GmbH, 82256 Fürstenfeldbruck (DE)
(72) Erfinder: Eckstein, Jens, 85221 Dachau (DE); Kellerer, Michael, 82256 Fürstenfeldbruck (DE); Hochholzer, Klaus, 86316 Friedberg (DE)
(74) Vertreter: Stöckeler, Ferdinand

(57) **Zusammenfassung**

Eine Vorrichtung zum Behandeln einer Oberfläche eines Substrats mit einer Flüssigkeit weist eine Halteeinrichtung auf, die ausgebildet ist, um das Substrat zu halten, wobei die Halteeinrichtung seitliche Begrenzungen für eine auf eine obere Oberfläche des Substrats aufgebrachte Flüssigkeit aufweist. Eine Transporteinrichtung ist vorgesehen, die ausgebildet ist, um die Halteeinrichtung mit dem Substrat parallel zu einer Transportrichtung zu transportieren und dabei mehrmals zu beschleunigen und mehrmals abzubremsen. Eine Hubeinrichtung ist vorgesehen, die ausgebildet ist, um zumindest eine Seite der Halteeinrichtung während des Transports anzuheben und abzusenken, um eine Neigung der oberen Oberfläche des Substrats quer zur Transportrichtung zu verändern.

## Beschreibung

Die vorliegenden Erfindung befasst sich mit Vorrichtungen und Verfahren, die es ermöglichen, eine Oberfläche eines Substrats mit einer Flüssigkeit bzw. einer in einer Flüssigkeit gelösten Substanz zu behandeln, um beispielsweise ein beschichtetes Substrat herzustellen.

Anwendungen, bei denen Substrate mit einer dünnen Schicht eines flüssigen Materials bedeckt werden müssen, sind vielfältig. Beispielsweise werden bei der Herstellung von Solarzellen in Dünnschichttechnologie Pufferschichten aus CdS/InS/Zn(O,S),ZnS (CdS = Cadmiumsulfid, Zn(O,S) = Zinkoxysulfid, ZnS = Zinksulfid, InS = Indiumsulfid) auf Substraten, wie z.B. Glassubstraten, Stahlfolien, Polymersubstraten oder Keramiksubstraten, abgeschieden. Entsprechende Dünnschichtanwendungen sind als CIS-Anwendungen, CIGS-Anwendungen, CIGSe-Anwendungen oder CIGSSe-Anwendungen bekannt. Jedoch existiert auch auf anderen Gebieten ein Bedarf nach einer gleichmäßigen Behandlung einer Substratoberfläche mit einer Flüssigkeit, wie z.B. beim Bearbeiten einer Halbleiteroberfläche durch Ätzen, bei dem es wesentlich ist, dass die Halbleiterobefläche mit einer gleichmäßigen Dicke von Ätzmittel kontrolliert bedeckt werden kann.

Aus der DE 10 2006 007 446 B3 sind Vorrichtungen und Verfahren zum gleichmäßigen Beschichten von Substraten bekannt, bei denen ein Substrat in einer Halteeinrichtung fixiert wird, wobei die Halteeinrichtung mit dem Substrat mittels einer Taumeleinrichtung in eine taumelnde Bewegung versetzt wird, so dass sich die Flüssigkeit auf der Oberfläche des Substrats gleichmäßig verteilt. Die Taumelbewegung wird dabei erreicht, indem das Substrat bezüglich zweier Achsen, die in einer zur Oberfläche des Substrats parallelen Ebene angeordnet sind, verkippt wird. Dadurch kann die Oberfläche des Substrats während der Behandlung derselben mit der Flüssigkeit gleichmäßig durch die Flüssigkeit bedeckt werden.

Die der vorliegenden Erfindung zugrundeliegende Aufgabe besteht darin, Vorrichtungen und Verfahren zum Behandeln einer Oberfläche eines Substrats mit einer Flüssigkeit zu schaffen, die eine Integration in automatisierte Anlagen vereinfachen.

Diese Aufgabe wird durch eine Vorrichtung nach Anspruch 1 und ein Verfahren nach Anspruch 11 gelöst.

Ausführungsbeispiele der Erfindung schaffen eine Vorrichtung zum Behandeln einer Oberfläche eines Substrats mit einer Flüssigkeit, mit folgenden Merkmalen:
einer Halteeinrichtung, die ausgebildet ist, um das Substrat zu halten, wobei die Halteeinrichtung seitliche Begrenzungen für eine auf eine obere Oberfläche des Substrats aufgebrachte Flüssigkeit aufweist;
einer Transporteinrichtung, die ausgebildet ist, um die Halteeinrichtung mit dem Substrat parallel zu einer Transportrichtung zu transportieren und dabei mehrmals zu beschleunigen und mehrmals abzubremsen; und
einer Hubeinrichtung, die ausgebildet ist, um zumindest eine Seite der Halteeinrichtung während des Transports anzuheben und abzusenken, um eine Neigung der oberen Oberfläche des Substrats quer zur Transportrichtung zu verändern.

Ausführungsbeispiele der Erfindung schaffen ein Verfahren zum Behandeln einer Oberfläche eines Substrats mit einer Flüssigkeit, mit folgenden Merkmalen:
Halten des Substrats mittels einer Halteeinrichtung, die seitliche Begrenzungen für eine auf eine obere Oberfläche des Substrats aufgebrachte Flüssigkeit aufweist;

Aufbringen einer Flüssigkeit auf die obere Oberfläche des Substrats;
Transportieren der Halteeinrichtung mit dem Substrat parallel zu einer Transportrichtung und mehrmaliges Beschleunigen und Abbremsen der Halteeinrichtung während des Transports; und

Anheben und Absenken zumindest einer Seite der Halteeinrichtung während des Transports, um eine Neigung der oberen Oberfläche des Substrats quer zur Transportrichtung zu verändern.

Ausführungsbeispiele der Erfindung basieren auf der Erkenntnis, dass es möglich ist, durch ein mehrmaliges Beschleunigen und Abbremsen der Halteeinrichtung und ein gleichzeitiges Anheben und Absenken von zumindest einer Seite der Halteeinrichtung, um eine Neigung der oberen Oberfläche des Substrats quer zur Transportrichtung zu verändern, möglich ist, eine Flüssigkeit, mit der die Oberfläche des Substrats behandelt werden soll, gleichmäßig auf der Oberfläche des Substrats zu verteilen. Ferner ermöglichen Ausführungsbeispiele der Erfindung, dass eine solche Behandlung in ein Inline-Verfahren, bei dem Substrate der Reihe nach nacheinander durch eine Fertigungsstraße laufen, integriert wird. Durch eine mehrmaliges Beschleunigen und Abbremsen und Anheben und Absenken einer Seite der Halteeinrichtung ist es möglich, eine Taumelbewegung, wie sie beispielsweise in der DE 10 2006 007 446 B3 gelehrt wird, nachzubilden, wobei jedoch nur ein Schwenken um eine Achse notwendig ist.

Anders ausgedrückt findet bei Ausführungsbeispielen der Erfindung ein Schwenken des Substrats um eine Achse, die parallel zur Transportrichtung ist, statt, um eine Verteilung der Flüssigkeit quer zur Transportrichtung zu erreichen. Um eine Verteilung der Flüssigkeit längs zur Transportrichtung zu erreichen, findet ein mehrmaliges Beschleunigen und Abbremsen der Halteeinrichtung statt. Durch eine Überlagerung der beiden Bewegungen kann somit eine Taumelbewegung nachgebildet werden, wodurch die Flüssigkeit gleichmäßig auf der Oberfläche des Substrats verteilt werden kann.

Bei Ausführungsbeispielen kann die Hubeinrichtung ausgebildet sein, um die zumindest eine Seite und/oder versetzt eine zweite Seite der Halteeinrichtung während des Transports anzuheben oder abzusenken, um eine Neigung der oberen Oberfläche des Substrats quer zur Transportrichtung zu verändern.

Bei Ausführungsbeispielen der Erfindung weist die Halteeinrichtung ein Unterteil für das Substrat und einen Rahmen auf, der ausgebildet ist, um auf die obere Oberfläche des Substrats aufgesetzt zu werden, wenn das Substrat auf dem Unterteil aufliegt, um mit der oberen Oberfläche des Substrats ein Prozessvolumen zu definieren. Dadurch kann der Verbrauch von Reagenzien bzw. Flüssigkeiten zur Beschichtung stark reduziert werden, da der Rahmen flüssigkeitsdicht auf das Substrat aufgesetzt werden kann.

Bei Ausführungsbeispielen ist die Transporteinrichtung ausgebildet, um die Halteeinrichtung in der Transportrichtung zu transportieren und während des Transport in Transportrichtung die Halteeinrichtung mehrmals zu beschleunigen und abzubremsen. Bei Ausführungsbeispielen kann die Transporteinrichtung ausgebildet sein, um die Halteeinrichtung ausgebildet sein, um die Halteeinrichtung in und entgegen der Transportrichtung zu transportieren, wobei das Beschleunigen und Abbremsen ein Umkehren der Bewegungsrichtung aufweisen kann.

Mittels der Hubeinrichtung kann bei Ausführungsbeispielen der Erfindung zumindest eine Seite der Halteeinrichtung in einer Richtung, die senkrecht zur Transportrichtung und senkrecht zu einer Richtung quer zur Transportrichtung ist, angehoben und abgesenkt werden.

Bei Ausführungsbeispielen der Erfindung weist die Transporteinrichtung Endloseinrichtungen auf, die quer zur Transportrichtung voneinander beabstandet sind und die Auflagen für die Halteeinrichtung aufweisen. Die Halteeinrichtung mit dem Substrat kann somit auf einfache Weise auf die Endloseinrichtungen aufgesetzt und durch dieselben transportiert werden. Die Hubeinrichtung kann ausgebildet sein, um eine der Endloseinrichtungen anzuheben und abzusenken. Bei alternativen Ausführungsbeispielen kann eine Hubeinrichtung für jede der Endloseinrichtungen vorgesehen sein, wobei die Hubeinrichtungen dann ausgebildet sind, um die Endloseinrichtungen gegenläufig anzuheben und abzusenken.

Bei Ausführungsbeispielen der Erfindung kann eine Benetzungseinrichtung vorgesehen sein, die ausgebildet ist, um eine Flüssigkeit auf die obere Oberfläche des Substrats aufzubringen, wobei diese Flüssigkeit durch das Beschleunigen und Abbremsen und das Anheben und Absenken der zumindest einen Seite der Halteeinrichtung auf der oberen Oberfläche des Substrats verteilt wird. Bei Ausführungsbeispielen kann das Beschleunigen und Abbremsen und das Anheben und Absenken periodisch erfolgen, so dass eine Taumelbewegung der oberen Oberfläche des Substrats nachgebildet wird, um die Verteilung der Flüssigkeit auf der oberen Oberfläche des Substrats zu erreichen.

Bei Ausführungsbeispielen kann eine Heizeinrichtung vorgesehen sein, um das Substrat während des Transports parallel zur Transportrichtung zu heizen. Dadurch ist es möglich, eine definierte Atmosphäre zu erzeugen, die für eine spezifische Behandlung vorteilhaft sein kann. Bei der Heizeinrichtung kann es sich um eine kontaktlose Strahlheizquelle handeln, oder die Heizeinrichtung kann ein flüssiges Medium aufweisen, welches die Substratunterseite berührt. Bei Ausführungsbeispielen der Erfindung kann die Heizeinrichtung einen Warmluftkanal aufweisen.

Bei Ausführungsbeispielen der Erfindung ist eine Beladestation zum Beladen der Halteeinrichtung mit dem Substrat und eine in Transportrichtung von der Beladestation beabstandete Entladestation zum Entladen des Substrats aus der Halteeinrichtung vorgesehen, wobei die Transporteinrichtung ausgebildet ist, um die Halteeinrichtung mit dem Substrat von der Beladestation zu der Entladestation zu transportieren. Dadurch können Ausführungsbeispiele der vorliegenden Erfindung ohne Weiteres in eine Inline-Anlage integriert werden. Bei Ausführungsbeispielen kann eine Rücktransporteinrichtung vorgesehen sein, die ausgebildet ist, um die Halteeinrichtung von der Entladestation zu der Beladestation zurückzutransportieren.

Ausführungsbeispiele der Erfindung ermöglichen somit ein Behandeln einer Oberfläche eines Substrats mit einer Flüssigkeit, die in eine Inline-Anlage integriert werden kann. Eine wesentlicher Vorteil dabei liegt in der Kostenreduktion, da Benetzungseinrichtungen (Dosiereinheiten), Heizeinrichtungen (zur Temperierung), und Mechanismus zum Nachbilden einer Taumelbewegung (der durch die Transporteinrichtung und die Hubeinrichtung implementiert ist) nur einmal pro Anlage verbaut werden müssen, und nicht pro Prozessmodul bzw. Substrat.

Ausführungsbeispiele der vorliegenden Erfindung eignen sich insbesondere für Dünnschichtanwendungen, bei denen beispielsweise Pufferschichten aus CdS/ZnS/Zn(O,S),InS auf Substraten, beispielsweise Glassubstraten, Stahlfolien, Polymersubstraten oder Keramiksubstraten nasschemisch abgeschieden werden. Die vorliegende Erfindung ist jedoch nicht auf solche Anwendungen begrenzt, sondern kann für andere Anwendungen verwendet werden, bei denen beispielsweise ein Ätzmittel gleichmäßig auf der Oberfläche eines Substrats verteilt werden soll.

Ausführungsbeispiele der Erfindung werden nachfolgend Bezug nehmend auf die beiliegenden Zeichnungen näher erläutert. Es zeigen:
- Fig. 1: eine schematische perspektivische Ansicht eines Ausführungsbeispiels einer erfindungsgemäßen Vorrichtung;
- Fig. 2: eine schematische Querschnittansicht eines Ausführungsbeispiels einer erfindungsgemäßen Vorrichtung; und
- Fig. 3a: und 3b eine schematische Seitenansicht bzw. eine schematische Draufsicht eines Ausführungsbeispiels einer erfindungsgemäßen Vorrichtung.

An dieser Stelle sei angemerkt, dass die Figuren schematischer Natur sind und jeweils nur die Merkmale zeigen, die zur Beschreibung der Erfindung notwendig sind.

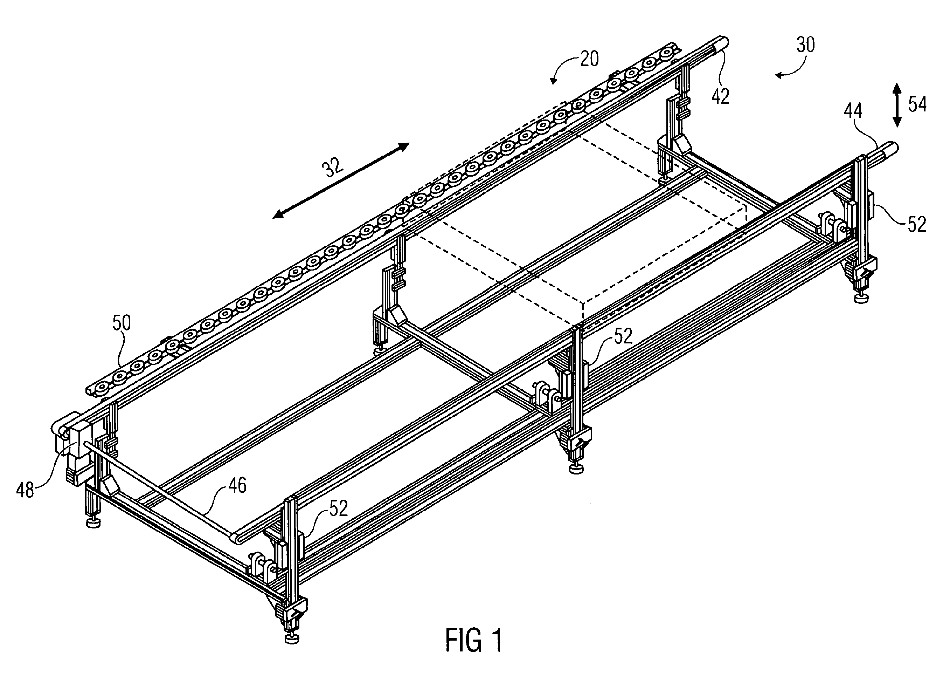

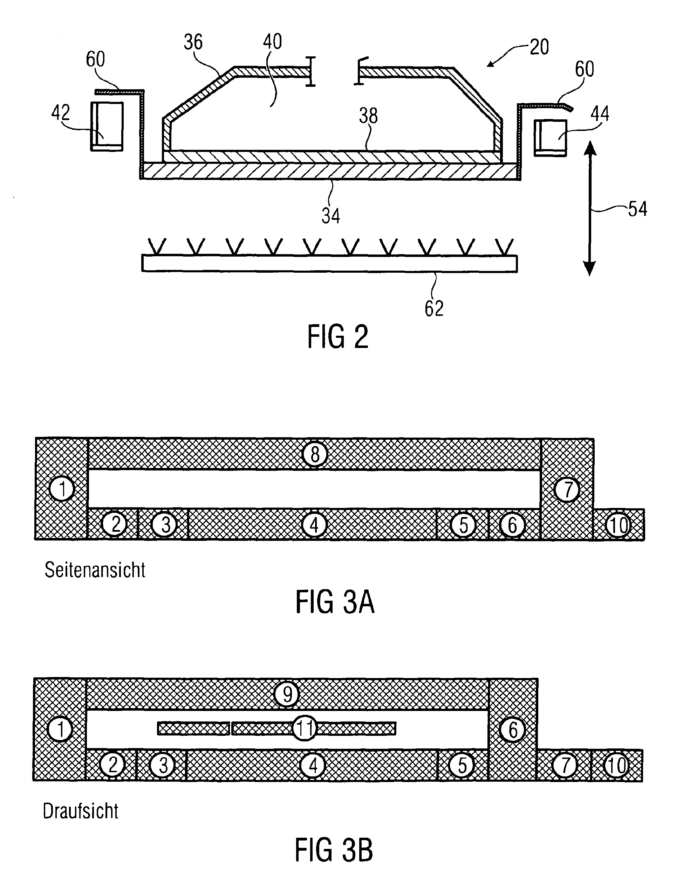

Ein Ausführungsbeispiel der Erfindung wird nachfolgend anhand der Figuren 1 und 2 beschrieben. Fig. 1 zeigt schematisch eine Halteeinrichtung 20, die mittels einer Transporteinrichtung 30 in einer Transportrichtung 32 bewegbar ist. Fig. 2 zeigt eine schematische Querschnittdarstellung der Vorrichtung quer zur Transportrichtung 32. Wie in Fig. 2 gezeigt ist, weist die Halteeinrichtung bei dem dargestellten Ausführungsbeispiel Unterteil 34 auf, das auch als Unterlage 34 bezeichnet werden kann. Bei der Unterlage kann es sich beispielsweise um eine Auflageplatte oder einen Auflagerahmen handeln. Die Halteeinrichtung 20 weist ferner ein Oberteil 36 auf, das ausgebildet ist, um von oben auf eine Substrat 38, das auf das Unterteil 34 aufgelegt ist, aufgesetzt zu werden. Genauer gesagt ist das untere Ende des Oberteils 36 rahmenförmig und ist ausgebildet, um auf den äußeren Rand des Substrats 38 aufgesetzt zu werden. Das untere Ende des Oberteils 36 ist vorzugsweise mit einer Dichtung versehen, um eine flüssigkeitsdichte Verbindung zwischen der Oberseite des Substrats 38 und dem Oberteil 36 zu bewirken. Das Oberteil 36 kann als Haube ausgebildet sein, in der eine oder mehrere Öffnungen vorgesehen sein können, um eine oder mehrere Flüssigkeiten bzw. Reagenzien in den durch die Oberseite des Substrats 38 und das Oberteil 36 gebildeten Prozessraum 40 einzubringen.

Insoweit kann die Halteeinrichtung, die zusammen mit dem Substrat 38 einen Prozessraum bzw. eine Prozesskammer 40 bildet, ähnlich der Halteeinrichtung ausgebildet sein, wie sie in der DE 10 2006 007 446 B3 beschrieben ist. Die diesbezügliche Lehre dieser Schrift wird hiermit durch Bezugnahme aufgenommen.

Bei dem gezeigten Ausführungsbeispiel ist die Halteeinrichtung 20 jedoch angepasst, um durch die Transporteinrichtung 30 entlang eines Transportweges parallel zu einer Transportrichtung 32 (in Transportrichtung oder in und entgegen der Transportrichtung) transportiert zu werden.

Die Transporteinrichtung 30 weist zwei quer zur Transportrichtung voneinander beabstandete Endloseinrichtungen 42 und 44 auf. Die Endloseinrichtungen können beispielsweise durch Zahnriemen oder Ketten gebildet sein. Bei dem gezeigten Ausführungsbeispiel sind die Endloseinrichtungen 42 und 44 durch Zahnriemen gebildet, die über entsprechende Rollen laufen. Die Zahnriemen 42 und 44 können beispielsweise über eine Antriebswelle 46 angetrieben werden, die wiederum durch einen Servomotor 48 angetrieben wird.

Bei alternativen Ausführungsbeispielen kann die Transporteinrichtung durch Rollen gebildet sein, mittels derer die Halteeinrichtung transportiert wird, wobei die Rollen angetrieben werden können, um die Halteeinrichtung mehrmals abzubremsen und zu beschleunigen.

Die Halteeinrichtung 20 mit dem Substrat, die zusammen als Sandwich-Prozesskammer bezeichnet werden können, können auf die Zahnriemen 42 und 44 aufgelegt werden. Die Zahnriemen 42 und 44 stellen somit eine Auflage für die Halteeinrichtung 20 dar. Die Halteeinrichtung 20 (bzw. die Sandwich-Prozesskammer mit dem Substrat) ist in Fig. 1 schematisch eingezeichnet. Wie in Fig. 1 gezeigt ist, können seitliche Führungsmittel 50 vorgesehen sein, die eine seitliche Bewegung (quer zur Transportrichtung) der Halteeinrichtung 20 begrenzen. Die Führungsmittel 50 können vorzugsweise Führungsrollen aufweisen, wobei entsprechende Führungsmittel 50 auf beiden Seiten der Halteeinrichtung 20 vorgesehen sein können.

Der Servomotor ist ausgebildet, um die Halteeinrichtung 20 parallel zur Transportrichtung zu transportieren und dabei mehrmals zu beschleunigen und abzubremsen. Anders ausgedrückt ist der Servomotor ausgebildet, um die Halteeinrichtung 20 einer Bewegung mit Beschleunigungsrampen und Entschleunigungsrampen zu unterwerfen. Bei Ausführungsbeispielen kann dabei auch eine Umkehr der Bewegungsrichtung stattfinden, so dass die Halteeinrichtung während dieser Bewegung auch entgegen der Transportrichtung bewegt werden kann, wie durch den bidirektionalen Pfeil 32 in Fig. 1 angedeutet ist.

Das in Fig. 1 gezeigte Ausführungsbeispiel weist eine Hubeinrichtung 52 für den Zahnriemen 44 auf. Durch die Hubeinrichtung 52 kann der Zahnriemen 44 angehoben und abgesenkt werden, wie durch einen bidirektionalen Pfeil 54 in Fig. 1 angedeutet ist. Zu diesem Zweck kann die Hubeinrichtung 52 einen oder mehrere Servomotoren und zugeordnete Umlenkgetriebe aufweisen, die ausgelegt sind, um den Zahnriemen 44 einer entsprechenden Anhebe- und Absenkbewegung zu unterwerfen.

Wie in Fig. 2 gezeigt ist, weist die Halteeinrichtung 20 seitliche Auflageelemente 60 auf, die ausgebildet sind, um auf den Zahnriemen 52 und 44 aufzuliegen. Wenn die Auflageelemente 60 auf den Zahnriemen 42 und 44 aufliegen, kann durch eine Aufwärts- und Abwärts-Bewegung 54 des Zahnriemens 44 die Neigung der Oberfläche des Substrats 38 quer zur Transportrichtung 32 verändert werden. In Fig. 2 ist ferner eine Heizeinrichtung 62 gezeigt, bei der es sich um eine Infrarot-Heizung oder ein temperierbares Flüssigkeitsbad (z.B. Wasserbad) handeln kann. Die Unterlage bzw. das Unterteil 34 kann bei Ausführungsbeispielen der Erfindung als eine durchgehende Platte ausgebildet sein, um zusammen mit der Heizeinrichtung 62 eine homogene Temperaturverteilung (parallel zur Substratoberfläche) in dem Substrat 38 bewirken zu können.

Eine Steuerung (nicht gezeigt) kann für die Servomotoren vorgesehen sein, um die Transporteinrichtung zu steuern, um entsprechende Beschleunigungen/Entschleunigungen der Halteeinrichtung zu bewirken, und die Hubeinrichtung bzw. die Hubeinrichtungen zu steuern, um ein entsprechendes Anheben und Absenken des Zahnriemens 44 zu bewirken. Bei alternativen Ausführungsbeispielen können Hubeinrichtungen für beide Zahnriemen vorgesehen sein, die gegenläufig betrieben werden, so dass, wenn der eine Zahnriemen angehoben wird, der andere abgesenkt wird, und umgekehrt.

Im Betrieb wird die Halteeinrichtung mit dem Substrat (d.h. die Sandwich-Prozesskammer) an einem Ende auf die Zahnriemen 42 und 44 aufgesetzt. Die Zahnriemen transportieren die Halteeinrichtung von dem Ende, an dem dieselbe aufgesetzt wird, zu dem davon beabstandeten Ende. Während dieses Transports durchfährt der Servomotor für die Zahnriemen 42 und 44 mehrere Beschleunigungs- und Entschleunigungs-Rampen, so dass die Halteeinrichtung 20 mehrmals, beispielsweise periodisch, beschleunigt und entschleunigt wird. Während dieser Beschleunigung und Entschleunigung kann auch eine Umkehrung der Transportrichtung stattfinden. Ferner findet während dieses Transports ein, vorzugsweise periodisches, Anheben und Absenken des Zahnriemens 44 statt. Somit kann durch eine entsprechende Bewegung der Halteeinrichtung eine Verteilung von Flüssigkeit auf dem Substrat 38 sowohl in der Transportrichtung (bidirektionaler Pfeil 32) als auch quer zur Transportrichtung bewirkt werden. Dadurch ist es möglich, eine Taumelbewegung des Substrats, wie sie gemäß der DE 102 006 007 446 B3 stationär über zwei Achsen ausgeführt wird, in einem Inline-Verfahren nachzustellen.

Mit anderen Worten findet die Taumelbewegung innerhalb der Prozesseinheit durch eine überlagerte Bewegung mit linearem Anteil statt. Um die Flüssigkeit bzw. die Chemikalien auf der Substratoberfläche prozessoptimiert in Bewegung zu versetzen, werden erfindungsgemäß nicht zwei Neigungen über zwei Achsen durchgeführt, sondern eine Neigung um eine Achse (parallel zur Transportrichtung), während die Bewegung um die andere Achse über eine zyklische Beschleunigung und Linearbewegung des Transportsystems simuliert wird. Somit kann durch eine Überlagerung der beiden Bewegungen eine Taumelbewegung der Substratoberfläche nachgebildet bzw. simuliert werden.

Die Hubeinrichtung kann bei Ausführungsbeispielen der Erfindung ausgebildet sein, um beliebige periodische Hubbewegungen der zumindest einen Seite der Halteeinrichtung zu bewirken. Beispielsweise kann die Hubeinrichtung ausgebildet sein, um die zumindest eine Seite der Halteeinrichtung derart während des Transports anzuheben und abzusenken, dass sich über die Transportstrecke ein sinusförmiger oder dreieckförmiger Hubverlauf ergibt. Bei Ausführungsbeispielen kann die Transporteinrichtung ausgebildet sein, um dreieckförmige oder sinusförmige Beschleunigungs/Entschleunigungsprotokolle zu durchlaufen.

Die Figuren 3a und 3b zeigen schematisch eine Seitenansicht und eine Draufsicht eines Ausführungsbeispiels einer erfindungsgemäßen Vorrichtung. Mit dem Bezugszeichen 1 ist eine Beladestation bezeichnet, in der das Substrat in die Halteeinrichtung beladen wird. Das Substrat wird, vorzugsweise von der Seite, zwischen das Unterteil 34 und das Oberteil eingebracht, woraufhin das Unterteil 34 und das Oberteil 36 verpresst werden, so dass am Rand des Substrats ein flüssigkeitsdichter Abschluss zwischen der Substratoberfläche und dem Oberteil 36 erfolgt. Die Halteeinrichtung mit dem Substrat, wobei diese Kombination im Folgenden als Prozesskammer bezeichnet wird, wird von der Beladestation zu einem Adapter-Abschnitt transportiert, wo die Prozesskammer von einer linearen Bewegung in die Taumelbewegung transferiert wird. Nach dem Adapterabschnitt 2 folgt ein Dosierabschnitt 2, in dem eine Flüssigkeit in den Prozessraum 40, d.h. auf die obere Oberfläche des Substrats 38 aufgebracht wird. Dabei können beispielsweise mehrere Reagenzien eingebracht werden, die beispielsweise Ammoniakwasser, Cadmiumsulfat- oder Cadmiumacetat, Thioharnstoff, VE-Wasser und eventuelle Zusatzkomponenten aufweisen. Unter Verwendung solcher Reagenzien kann beispielsweise eine Cadmiumsulfidbeschichtung auf einer Glasplatte erfolgen.

Hinsichtlich weiterer Einzelheiten bezüglich entsprechender Reagenzien kann beispielsweise wiederum auf die DE 102 006 007 446 B3 verwiesen werden, deren diesbezügliche Lehre hiermit durch Bezugnahme aufgenommen wird.

Mit dem Bezugszeichen 4 ist in den Figuren 3 a und 3b ein Prozessabschnitt bezeichnet, in dem beispielsweise unter Verwendung der oben Bezug nehmend auf die Figuren 1 und 2 beschriebenen Vorrichtung Behandlungsflüssigkeit gleichmäßig auf der Oberseite des Substrats 38 verteilt wird. Nach Abschluss der Behandlung gelangt die Prozesskammer in einen weiteren Adapterabschnitt 5, in dem die Prozesskammer von der "Taumelbewegung" wieder in eine lineare Bewegung transferiert wird.

Um die Prozesskammer zu verpressen, kann bei Ausführungsbeispielen der Erfindung ein unterer Verriegelungsrahmen vorgesehen sein. Alternativ kann das Oberteil durch Schwerkraft auf dem Substrat gehalten werden, um die Prozesskammer zu bilden. In einem Prozessabschnitt 6 erfolgt eine Entriegelung des unteren Verriegelungsrahmens. Der untere Verriegelungsrahmen wird dann mittels eines Rücktransportsystems 9 zur Beladestation zurückgeführt. In einer Entladestation 7 wird das behandelte Substrat aus der Halteeinrichtung 20 entladen. Die Halteeinrichtung 20 wird dann über ein Rücktransportsystem 8 zu der Beladestation zurückgeführt. Während des Rücktransports kann die Halteeinrichtung 20 chemisch behandelt werden. Das entladene Substrat 10 kann einer nachfolgenden Spülstation 10 zugeführt werden, wo es einem abschließenden Spülen oder chemischem Behandeln unterworfen wird.

In Fig. 3 ist schematisch ferner eine Steuerung 11 dargestellt, die beispielsweise in Schaltschränken implementiert sein kann. Diese können zwischen dem Prozessorabschnitt 4 und dem Rücktransportsystem 9 für den unteren Verriegelungsrahmen angeordnet sein.

Ausführungsbeispiele der vorliegenden Erfindung ermöglichen somit eine Integration einer Behandlung einer Substratoberfläche in ein Inline-System, wobei Flüssigkeit gleichmäßig sowohl in Transportrichtung als auch quer zur Transportrichtung über die Substratoberfläche verteilt werden kann. Die vorliegende Erfindung ermöglicht somit, verglichen mit stationären Systemen einen erhöhten Durchsatz bei geringeren Kosten.

Die vorliegenden Erfindung eignet sich insbesondere zur Behandlung von flächigen Substraten, deren Höhe um ein Vielfaches geringer ist als deren übrige Abmessungen und deren Hauptoberflächen durch zwei gegenüberliegende, im wesentlichen Oberflächen gebildet sind. Durch die Hubeinrichtung kann beispielsweise eine Verkippung der oberen Oberfläche eines solchen Substrats um einen Winkel von bis zu +/- 30° bezüglich der Horizontalen bewirkt werden. Bezüglich weiterer Einzelheiten hinsichtlich der Reagenzien bzw. Prozesse, die unter Verwendung von Ausführungsbeispielen der Erfindung implementiert werden können, sei wiederum auf die DE 10 2006 007 446 B3 verwiesen, deren diesbezügliche Lehre hiermit durch Bezugnahme aufgenommen wird.

## Patentansprüche

1. Vorrichtung zum Behandeln einer Oberfläche eines Substrats (38) mit einer Flüssigkeit, mit folgenden Merkmalen:
einer Halteeinrichtung (20), die ausgebildet ist, um das Substrat (38) zu halten, wobei die Halteeinrichtung (20) seitliche Begrenzungen für eine auf eine obere Oberfläche des Substrats (38) aufgebrachte Flüssigkeit aufweist;
einer Transporteinrichtung (30), die ausgebildet ist, um die Halteeinrichtung (20) mit dem Substrat (38) parallel zu einer Transportrichtung (32) zu transportieren und dabei mehrmals zu beschleunigen und mehrmals abzubremsen; und
einer Hubeinrichtung (52), die ausgebildet ist, um zumindest eine Seite der Halteeinrichtung (20) während des Transports anzuheben und abzusenken, um eine Neigung der oberen Oberfläche des Substrats (38) quer zur Transportrichtung (32) zu verändern.

2. Vorrichtung nach Anspruch 1, bei der die Halteeinrichtung (20) ein Unterteil (34) für das Substrat (38) und einen Rahmen (36) aufweist, der ausgebildet ist, um auf die obere Oberfläche des Substrats (38) aufgesetzt zu werden, wenn das Substrat (38) auf dem Unterteil (34) aufliegt, um mit der oberen Oberfläche des Substrats (38) ein Prozessvolumen (40) zu definieren.

3. Vorrichtung nach Anspruch 1 oder 2, bei der die Transporteinrichtung (30) zwei quer zur Transportrichtung (32) voneinander beabstandete Endloseinrichtungen (42, 44) aufweist, die Auflagen für die Halteeinrichtung (20) aufweisen.

4. Vorrichtung nach Anspruch 3, bei der die Hubeinrichtung (52) ausgebildet ist, um eine oder beide der Endloseinrichtungen (42, 44) anzuheben und abzusenken.

5. Vorrichtung nach einem der Ansprüche 1 bis 4, die eine Benetzungseinrichtung aufweist, die ausgebildet ist, um eine Flüssigkeit auf die obere Oberfläche des Substrats (38) aufzubringen, die durch das Beschleunigen und Abbremsen und das Anheben und Absenken der zumindest einen Seite der Halteeinrichtung (20) auf der oberen Oberfläche des Substrats (38) verteilt wird.

6. Vorrichtung nach einem der Ansprüche 1 bis 5, die ferner ein Heizeinrichtung (62) aufweist, um das Substrat (38) während des Transports zu heizen.

7. Vorrichtung nach einem der Ansprüche 1 bis 6, die eine Beladestation (1) zum Beladen der Halteeinrichtung (20) mit dem Substrat (38) und eine in Transportrichtung (32) von der Beladestation (1) beabstandete Entladestation (7) zum Entladen des Substrats (38) aus der Halteeinrichtung (20) aufweist, wobei die Transporteinrichtung (30) ausgebildet ist, um die Halteeinrichtung (20) mit dem Substrat (38) von der Beladestation (1) zu der Entladestation (7) zu transportieren.

8. Vorrichtung nach Anspruch 7, die ferner eine Rücktransporteinrichtung (8) aufweist, die ausgebildet ist, um die Halteeinrichtung (20) von der Entladestation (7) zu der Beladestation (1) zurück zu transportieren.

9. Vorrichtung nach einem der Ansprüche 1 bis 8, bei der die Transporteinrichtung (30) ausgebildet ist, um die Halteeinrichtung (20) periodisch zu beschleunigen und abzubremsen und die Hubeinrichtung (52) ausgebildet ist, um die zumindest eine Seite der Halteeinrichtung (20) periodisch anzuheben und abzusenken, um eine Taumelbewegung der oberen Oberfläche des Substrats (38) nachzubilden, um eine Flüssigkeit auf der oberen Oberfläche des Substrats (38) zu verteilen.

10. Vorrichtung nach einem der Ansprüche 1 bis 9, die seitliche Führungseinrichtungen aufweist, die eine Bewegung der Halteeinrichtung (20) quer zur Transportrichtung (32) begrenzen.

11. Verfahren zum Behandeln einer Oberfläche eines Substrats (38) mit einer Flüssigkeit, mit folgenden Merkmalen:
Halten des Substrats (38) mittels einer Halteeinrichtung (20), die seitliche Begrenzungen für eine auf eine obere Oberfläche des Substrats (38) aufgebrachte Flüssigkeit aufweist;
Aufbringen einer Flüssigkeit auf die obere Oberfläche des Substrats (38);
Transportieren der Halteeinrichtung (20) mit dem Substrat (38) parallel zu einer Transportrichtung (32) und mehrmaliges Beschleunigen und Abbremsen der Halteeinrichtung (20) während des Transports; und
Anheben und Absenken zumindest einer Seite der Halteeinrichtung (20) während des Transports, um eine Neigung der oberen Oberfläche des Substrats (38) quer zur Transportrichtung (32) zu verändern.

12. Verfahren nach Anspruch 11, bei dem die Halteeinrichtung (20) periodisch beschleunigt und abgebremst wird und die zumindest eine Seite der Halteeinrichtung (20) periodisch angehoben und abgesenkt wird, um eine Taumelbewegung der oberen Oberfläche des Substrats (38) nachzubilden, um die Flüssigkeit auf der oberen Oberfläche des Substrats (38) zu verteilen.

13. Verfahren nach einem der Ansprüche 11 oder 12, das ferner ein Beladen der Halteeinrichtung (20) mit dem Substrat (38) an einer Beladestation (1), ein Transportieren des Substrats (38) von der Beladestation (1) zu einer Entladestation (7), während die Halteeinrichtung (20) mehrmals beschleunigt und abgebremst und die zumindest eine Seite der Halteeinrichtung (20) angehoben und abgesenkt wird, und ein Entladen des Substrats (38) aus der Halteeinrichtung (20) an der in Transportrichtung (32) von der Beladestation (1) beabstandeten Entladestation (7) aufweist.

14. Verfahren zum Herstellen eines beschichteten Substrats (38), das ein Verfahren zum Behandeln einer Oberfläche eines Substrats (38) gemäß einem der Ansprüche 11 bis 13 aufweist, wobei durch die Behandlung eine Beschichtung auf der oberen Oberfläche des Substrats (38) bewirkt wird.

15. Verfahren nach Anspruch 14 zum Herstellen eines mit Cadmiumsulfid, Zinksulfid, Zinkoxysulfid oder Indiumsulfid beschichteten Substrats (38).
